# DEMANDE DE BREVET EUROPEEN

(11) **EP 3 758 053 A1**
(43) Date de publication de la demande: **30.12.2020**
(21) Numéro de dépôt: 20182438.0
(22) Date de dépôt: 26.06.2020
(51) Int. Cl.: H01L 21/8222, H01L 27/06, H01L 29/66, H01L 29/93, H01L 29/10, H01L 29/737

(54) **PROCÉDÉ DE RÉALISATION D'UNE DIODE À CAPACITÉ VARIABLE ET D'UN TRANSISTOR BIPOLAIRE**

(30) Priorité: 28.06.2019 FR 1907149
(71) Demandeur: STMicroelectronics (Crolles 2) SAS, 38920 Crolles (FR)
(72) Inventeur: CHEVALIER, Pascal, 38530 CHAPAREILLAN (FR); GAUTHIER, Alexis, 38240 MEYLAN (FR); AVENIER, Gregory, 38330 SAINT NAZAIRE LES EYMES (FR)
(74) Mandataire: Cabinet Beaumont

(57) **Abrégé**

La présente description concerne un procédé de réalisation, conjointement sur un même substrat (500), d'au moins un transistor bipolaire (300) et d'au moins une diode à capacité variable (100).

## Description

### Procédé de réalisation d'une diode

### Domaine technique

La présente description concerne de façon générale les procédés de réalisation de composants électroniques et, plus particulièrement, les procédés de réalisation de diodes à capacité variable, également appelées diodes varicap ou encore varactors.

### Technique antérieure

Une diode varicap est un dipôle électronique doté de deux bornes entre lesquelles est formée une jonction p-n.

Lorsqu'elle est soumise à une polarisation directe, la diode varicap présente un fonctionnement analogue à celui d'une diode classique, c'est-à-dire qu'elle devient passante une fois dépassé un certain seuil de tension.

En revanche, si l'on applique à ses bornes une tension de polarisation inverse, la diode varicap se distingue d'une diode classique à l'état bloqué en ce qu'elle se comporte théoriquement non pas comme un circuit ouvert, mais plutôt comme un condensateur. En pratique, un phénomène capacitif similaire se produit aussi, mais dans une moindre mesure, pour une diode classique polarisée en inverse.

Tandis que l'on cherche plutôt à éviter ce phénomène capacitif dans le cas d'une diode classique, on s'efforce de le favoriser autant que possible dans le cas d'une diode varicap.

### Résumé de l'invention

Il existe un besoin d'augmenter la capacité électrique des diodes varicap actuelles. Il existe, en outre, un besoin d'améliorer les procédés permettant de réaliser une diode varicap.

Un mode de réalisation pallie tout ou partie des inconvénients des diodes varicap et de leurs procédés de réalisation connus.

Un mode de réalisation prévoit un procédé de réalisation, conjointement sur un même substrat, d'au moins un transistor bipolaire et d'au moins une diode à capacité variable, le procédé comprenant les étapes de :
former une première région, d'un premier type de conductivité, d'une jonction p-n de la diode à capacité variable, la première région étant située au-dessus d'une deuxième région, d'un deuxième type de conductivité, de la jonction p-n ;
former un collecteur intrinsèque, du deuxième type de conductivité, une base intrinsèque, du premier type de conductivité, et un émetteur intrinsèque, du deuxième type de conductivité, du transistor bipolaire, le collecteur intrinsèque étant situé au-dessus d'une troisième région (520) du deuxième type de conductivité ;
former des premiers espaceurs de part et d'autre de la première région de la jonction p-n de la diode à capacité variable ; et
former des deuxièmes espaceurs de part et d'autre du collecteur intrinsèque du transistor bipolaire.

Selon un mode de réalisation, la première région de la jonction p-n de la diode et une base extrinsèque du transistor sont réalisées au cours d'une même étape.

Selon un mode de réalisation, la première région est réalisée à l'aplomb d'une région de collecteur extrinsèque constituant la deuxième région.

Selon un mode de réalisation, la première région est réalisée par épitaxie.

Selon un mode de réalisation, un secteur de la deuxième région est dopé par implantation ionique.

Selon un mode de réalisation, le premier type de conductivité est p et le deuxième type de conductivité est n.

Selon un mode de réalisation, le premier type de conductivité est n et le deuxième type de conductivité est p.

Selon un mode de réalisation, la diode est un varactor à jonction p-n hyperabrupte.

Un mode de réalisation prévoit un procédé tel que décrit, comportant les étapes suivantes :
prévoir un substrat à l'intérieur duquel la troisième région, délimitée latéralement par une première tranchée d'isolation profonde et par une deuxième tranchée d'isolation profonde, comporte un premier puits intercalé entre ladite première tranchée d'isolation profonde et une première tranchée d'isolation peu profonde et à l'intérieur duquel ladite deuxième région de collecteur extrinsèque, délimitée latéralement par une troisième tranchée d'isolation profonde et par ladite première tranchée d'isolation profonde, comporte un deuxième puits, intercalé entre ladite troisième tranchée d'isolation profonde et une deuxième tranchée d'isolation peu profonde, et un troisième puits intercalé entre ladite première tranchée d'isolation profonde et une troisième tranchée d'isolation peu profonde ;
former, en surface dudit substrat, un empilement constitué d'une première couche, d'une deuxième couche, recouvrant ladite première couche, d'une troisième couche, recouvrant ladite deuxième couche, d'une quatrième couche, recouvrant ladite troisième couche, d'une cinquième couche, recouvrant ladite quatrième couche et d'une sixième couche, recouvrant ladite cinquième couche ;
pratiquer, dans ledit empilement et à l'aplomb d'une partie de ladite surface dudit substrat où affleure ladite troisième région, une ouverture traversante séparant ledit empilement en un premier empilement constitué de premières zones desdites couches et en un deuxième empilement constitué de deuxièmes zones desdites couches ;
réaliser, dans ladite première ouverture, le collecteur intrinsèque et la base intrinsèque, la base intrinsèque recouvrant intégralement le collecteur intrinsèque ;
réaliser, dans ladite première ouverture, deux troisièmes espaceurs comportant chacun une première partie et une deuxième partie, ladite première partie de chaque troisième espaceur étant constituée d'une portion horizontale, recouvrant partiellement la surface supérieure de la base intrinsèque, et d'une portion verticale affleurant la surface supérieure de ladite première zone de ladite sixième couche ou la surface supérieure ladite deuxième zone de ladite sixième couche ;
éliminer ladite première zone de ladite sixième couche, ladite deuxième zone de ladite sixième couche, lesdites portions verticales desdites premières parties desdits espaceurs et lesdites deuxièmes parties desdits troisièmes espaceurs ;
réaliser un troisième dépôt au-dessus dudit deuxième dépôt, desdites portions horizontales desdites premières parties desdits espaceurs, d'une portion de ladite première zone de ladite cinquième couche et d'une portion de ladite deuxième zone de ladite cinquième couche ;
éliminer ladite première zone de ladite cinquième couche à l'exception de ladite portion de ladite première zone de ladite cinquième couche et éliminer ladite deuxième zone de ladite cinquième couche à l'exception de ladite portion de ladite deuxième zone de ladite cinquième couche ;
déposer une septième couche recouvrant la surface supérieure dudit troisième dépôt, les surfaces latérales dudit troisième dépôt, les surfaces latérales de ladite portion de ladite première zone de ladite cinquième couche et les surfaces latérales de ladite portion de ladite deuxième zone de ladite cinquième couche ;
éliminer la totalité de ladite première zone de ladite quatrième couche et la totalité de ladite deuxième zone de ladite quatrième couche ;
réaliser, au-dessous de ladite portion de ladite première zone de ladite cinquième couche et d'une portion verticale de ladite septième couche, un premier lien contactant la base intrinsèque et réaliser, au-dessous de ladite portion de ladite deuxième zone de ladite cinquième couche et d'une portion verticale de ladite septième couche, un deuxième lien contactant la base intrinsèque ;
pratiquer, à travers lesdites premières zones desdites première, deuxième et troisième couches et à l'aplomb d'une partie de ladite surface dudit substrat où affleurent ladite deuxième région de collecteur extrinsèque, une partie de ladite deuxième tranchée d'isolation peu profonde et une partie de ladite troisième tranchée d'isolation peu profonde, une deuxième ouverture séparant ladite première zone de ladite première couche en une première portion et en une deuxième portion, séparant ladite première zone de ladite deuxième couche en une première portion et en une deuxième portion et séparant ladite première zone de ladite troisième couche en une première portion et en une deuxième portion.

Un mode de réalisation prévoit un procédé tel que décrit comportant, en outre, les étapes suivantes :
éliminer la totalité de ladite première portion de ladite première zone de ladite troisième couche, éliminer ladite deuxième portion de ladite première zone de ladite troisième couche à l'exception d'un premier élément situé à l'aplomb dudit premier lien et éliminer ladite deuxième zone de ladite troisième couche à l'exception d'un deuxième élément situé à l'aplomb dudit deuxième lien ;
réaliser une huitième couche, une première zone de ladite huitième couche recouvrant une partie de la surface de la deuxième zone de ladite deuxième couche non recouverte par ledit deuxième élément, une deuxième zone de ladite huitième couche recouvrant totalement ladite première portion de ladite première zone de ladite deuxième couche, une troisième zone de ladite huitième couche recouvrant une partie de la surface de la deuxième portion de ladite première zone de ladite deuxième couche non recouverte par ledit premier élément et une quatrième zone de ladite huitième couche constituant ladite première région ;
déposer une couche sacrificielle, une première portion de ladite couche sacrificielle recouvrant ladite première région et une deuxième portion de ladite couche sacrificielle recouvrant ladite septième couche, ledit premier lien et ledit deuxième lien, ladite deuxième portion de ladite couche sacrificielle s'étendant latéralement sur un premier élément de ladite troisième zone de ladite huitième couche et sur un deuxième élément de ladite première zone de ladite huitième couche ;
éliminer des parties desdites zones et portions de ladite huitième couche et de ladite deuxième couche non recouvertes par lesdites première et deuxième portions de ladite couche sacrificielle ;
éliminer totalement ladite première portion de ladite première zone de ladite première couche, éliminer ladite deuxième portion de ladite première zone de ladite première couche à l'exception d'un cinquième élément recouvert par ledit troisième élément et éliminer ladite deuxième zone de ladite première couche à l'exception d'un sixième élément recouvert par ledit quatrième élément ;
réaliser les premiers espaceurs de part et d'autre de ladite première région, réaliser les deuxièmes espaceurs de part et d'autre du collecteur intrinsèque et réaliser des quatrièmes espaceurs de part et d'autre de la base intrinsèque ;
réaliser un premier élément de reprise de contact sur ladite deuxième tranchée, un deuxième élément de reprise de contact sur ladite troisième tranchée, un troisième élément de reprise de contact sur ladite première région, un quatrième élément de reprise de contact sur ledit premier puits, un cinquième élément de reprise de contact sur ledit premier élément de ladite troisième zone de ladite huitième couche, un sixième élément de reprise de contact sur ledit deuxième élément de ladite première zone de ladite huitième couche et un septième élément de reprise de contact sur ledit troisième dépôt, lesdits premier, deuxième et troisième éléments de reprise de contact constituant des bornes de ladite diode à capacité variable, ledit quatrième élément de reprise de contact constituant une borne de collecteur dudit transistor bipolaire, lesdits cinquième et septième éléments de reprise de contact constituant des bornes de base dudit transistor bipolaire et ledit huitième élément de reprise de contact constituant une borne d'émetteur dudit transistor bipolaire.

Un mode de réalisation prévoit un circuit électronique comportant au moins un varactor et au moins un transistor bipolaire, obtenus par le procédé tel que décrit.

### Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :
La figure 1 représente, de façon schématique et en coupe, une étape d'un mode de mise en œuvre d'un procédé de réalisation d'une diode varicap et d'un transistor bipolaire ;
La figure 2 représente, de façon schématique et en coupe, une autre étape du mode de mise en œuvre du procédé de réalisation d'une diode varicap et d'un transistor bipolaire ;
La figure 3 représente, de façon schématique et en coupe, encore une autre étape du mode de mise en œuvre du procédé de réalisation d'une diode varicap et d'un transistor bipolaire ;
La figure 4 représente, de façon schématique et en coupe, encore une autre étape du mode de mise en œuvre du procédé de réalisation d'une diode varicap et d'un transistor bipolaire ;
La figure 5 représente, de façon schématique et en coupe, encore une autre étape du mode de mise en œuvre du procédé de réalisation d'une diode varicap et d'un transistor bipolaire ;
La figure 6 représente, de façon schématique et en coupe, encore une autre étape du mode de mise en œuvre du procédé de réalisation d'une diode varicap et d'un transistor bipolaire ;
La figure 7 représente, de façon schématique et en coupe, encore une autre étape du mode de mise en œuvre du procédé de réalisation d'une diode varicap et d'un transistor bipolaire ;
La figure 8 représente, de façon schématique et en coupe, encore une autre étape du mode de mise en œuvre du procédé de réalisation d'une diode varicap et d'un transistor bipolaire ;
La figure 9 représente, de façon schématique et en coupe, encore une autre étape du mode de mise en œuvre du procédé de réalisation d'une diode varicap et d'un transistor bipolaire ;
La figure 10 représente, de façon schématique et en coupe, encore une autre étape du mode de mise en œuvre du procédé de réalisation d'une diode varicap et d'un transistor bipolaire ;
La figure 11 représente, de façon schématique et en coupe, encore une autre étape du mode de mise en œuvre du procédé de réalisation d'une diode varicap et d'un transistor bipolaire ;
La figure 12 représente, de façon schématique et en coupe, encore une autre étape du mode de mise en œuvre du procédé de réalisation d'une diode varicap et d'un transistor bipolaire ;
La figure 13 représente, de façon schématique et en coupe, encore une autre étape du mode de mise en œuvre du procédé de réalisation d'une diode varicap et d'un transistor bipolaire ;
La figure 14 représente, de façon schématique et en coupe, encore une autre étape du mode de mise en œuvre du procédé de réalisation d'une diode varicap et d'un transistor bipolaire ;
La figure 15 représente, de façon schématique et en coupe, encore une autre étape du mode de mise en œuvre du procédé de réalisation d'une diode varicap et d'un transistor bipolaire ;
La figure 16 représente, de façon schématique et en coupe, encore une autre étape du mode de mise en œuvre du procédé de réalisation d'une diode varicap et d'un transistor bipolaire ;
La figure 17 représente, de façon schématique et en coupe, encore une autre étape du mode de mise en œuvre du procédé de réalisation d'une diode varicap et d'un transistor bipolaire ; et
La figure 18 représente des courbes de variation d'une grandeur caractéristique des diodes varicap obtenues selon le mode de mise en œuvre du procédé tel que décrit.

### Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, le procédé de préparation du substrat n'est pas détaillé.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

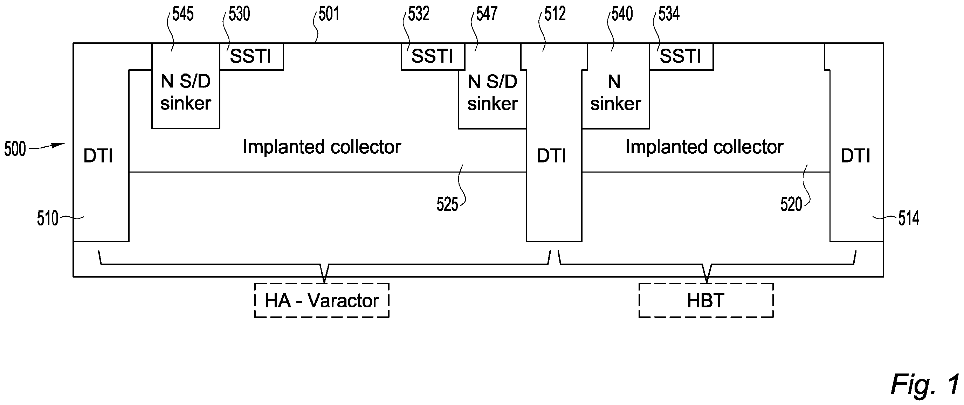

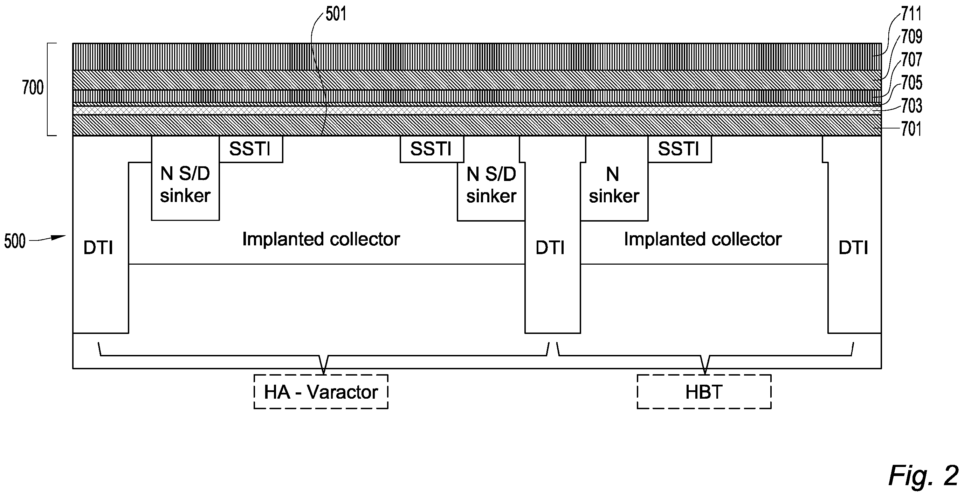

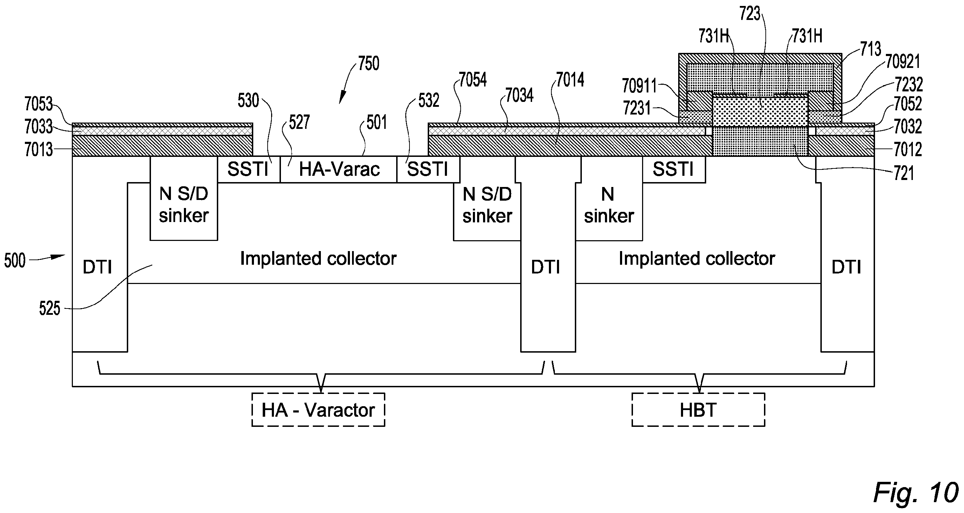

Les figures 1 à 17 ci-dessous illustrent des étapes successives d'un même mode de mise en œuvre d'un procédé de réalisation d'une diode varicap 100 ou diode à capacité variable 100 ou varistor 100. Selon ce mode de mise en œuvre, la diode varicap 100 est co-intégrée avec un transistor 300 bipolaire à hétérojonction (Heterojunction Bipolar Transistor - HBT), ici de type BiCMOS (Bipolar CMOS). En d'autres termes, le mode de mise en œuvre décrit permet la réalisation, sur un même substrat et de façon conjointe, d'un transistor bipolaire 300 et d'une diode varicap 100. Les figures 2 à 9 ci-dessous représentent des étapes plus particulièrement dédiées à la réalisation du transistor bipolaire 300. Les figures 10 à 12 ci-dessous représentent quant à elles des étapes plus particulièrement dédiées à la réalisation de la diode varicap 100.

Pour simplifier, ce qui est exposé ci-dessous en relation avec les figures 1 à 17 prend pour exemple un procédé dans lequel une seule diode à capacité variable 100 et un seul transistor bipolaire 300 sont conjointement réalisés. Néanmoins, il est entendu que ce procédé peut être étendu à la réalisation, conjointe et sur un même substrat, d'un nombre quelconque de transistors bipolaires 300 et d'un nombre quelconque de diodes à capacité variable 100, ces deux nombres pouvant être différents.

La figure 1 représente, de façon schématique et en coupe, une étape d'un mode de mise en œuvre d'un procédé de réalisation d'une diode varicap et d'un transistor bipolaire.

Selon ce mode de mise en œuvre, on commence par prévoir un substrat 500 constitué, par exemple, d'une plaquette de silicium monocristallin. En figure 1, le substrat 500 comporte des premières structures 510, 512 et 514 (DTI) isolantes, par exemple, des tranchées ou rainures d'isolation profondes (Deep Trench Isolation - DTI). Ces tranchées d'isolation profondes 510, 512 et 514 s'étendent verticalement depuis une surface supérieure 501 du substrat 500. Les tranchées 510, 512 et 514 délimitent ainsi latéralement, dans le substrat 500, deux emplacements :
un premier emplacement (HA-Varactor, pour Hyperabrupt Varactor), compris entre les tranchées 510 et 512, où l'on souhaite réaliser la diode à capacité variable 100, désigné ci-après par l'expression « emplacement de la diode » (à gauche, en figure 1) ; et
un deuxième emplacement (HBT, pour Heterojunction Bipolar Transistor), compris entre les tranchées 512 et 514, où l'on souhaite réaliser le transistor bipolaire 300, désigné ci-après par l'expression « emplacement du transistor » (à droite, en figure 1).

Les tranchées d'isolation profondes 510, 512 et 514 du substrat 500 séparent, en figure 1, deux régions 520, 525 (Implanted collector) de collecteur extrinsèque. Les régions 520 et 525 s'étendent verticalement en remontant, vers la surface supérieure 501 du substrat 500, à partir d'une profondeur inférieure à celle des tranchées 510, 512 et 514. Plus précisément :
une première région 520 de collecteur extrinsèque, située à l'emplacement du transistor, est intercalée entre les tranchées d'isolation profondes 512 et 514 ; et
une deuxième région 525 de collecteur extrinsèque, située à l'emplacement de la diode, est intercalée entre les tranchées d'isolation profondes 510 et 512.

Les régions 520 et 525 de collecteur extrinsèque sont donc séparées l'une de l'autre par une tranchée d'isolation commune, en l'occurrence la tranchée 512 en figure 1. Ces régions 520 et 525 de collecteur extrinsèque sont, par exemple, obtenues par implantation ionique, sous la surface supérieure 501 du substrat 500, d'un élément dopant d'un premier type de conductivité, par exemple, de type n (par exemple du phosphore ou de l'arsenic). Les régions 520 et 525 possèdent alors une concentration en élément dopant d'autant plus forte que l'on s'éloigne de la surface supérieure 501 du substrat 500.

Le substrat 500 comporte, en outre, des deuxièmes structures 530, 532 et 534 (SSTI) isolantes, par exemple, des tranchées ou rainures d'isolation très peu profondes (Super Shallow Trench Isolation - SSTI). Ces tranchées 530, 532 et 534 s'étendent verticalement, depuis la surface supérieure 501 du substrat 500, jusqu'à une profondeur inférieure à celle des régions 520 et 525. Les tranchées d'isolation peu profondes 530, 532 et 534 possèdent une profondeur comprise entre environ 50 nm et environ 100 nm, de préférence comprise entre 50 nm et 100 nm.

Un premier puits 540 (N sinker), situé à l'emplacement du transistor, est intercalé entre la tranchée 512 et la tranchée 534. Ce premier puits 540 est du premier type de conductivité, dans cet exemple, le type n.

Deux deuxièmes puits 545 et 547 (N S/D sinker), situés à l'emplacement de la diode, sont respectivement intercalés :
entre la tranchée d'isolation profonde 510 et la tranchée d'isolation peu profonde 530, pour le puits 545 ; et
entre la tranchée d'isolation peu profonde 532 et la tranchée d'isolation profonde 512, pour le puits 547.

Ces deuxièmes puits 545 et 547 sont du premier type de conductivité, dans cet exemple, le type n.

Les premier puits 540 et deuxièmes puits 545, 547 s'étendent verticalement, depuis la surface supérieure 501 du substrat 500, à l'intérieur des première et deuxième régions 520, 525 de collecteur extrinsèque, respectivement. En d'autres termes, les puits 540, 545 et 547 permettent, depuis la surface supérieure 501 du substrat 500, de contacter respectivement les régions 520 et 525 de collecteur extrinsèque.

En figure 1, la région 520 de collecteur extrinsèque est bordée de part et d'autre par les tranchées 512 et 514 d'isolation profondes (respectivement situées à gauche et à droite de la région 520, en figure 1). Le puits 540 est accolé à la tranchée d'isolation profonde 512 (à droite de la tranchée 512, en figure 1). La tranchée d'isolation peu profonde 534 est accolée au puits 540 du côté où le puits 540 ne touche pas la tranchée 512 d'isolation profonde (du côté droit, en figure 1). Une partie de la région 520 de collecteur extrinsèque affleure la surface 501 du substrat 500 entre la tranchée d'isolation peu profonde 534 et la tranchée d'isolation profonde 514.

En figure 1, la région 525 de collecteur extrinsèque est bordée de part et d'autre par les tranchées 510 et 512 d'isolation profondes (respectivement situées à gauche et à droite de la région 525, en figure 1). Le puits 545 est accolé à la tranchée d'isolation profonde 510 (à droite de la tranchée 510, en figure 1). La tranchée d'isolation peu profonde 530 est accolée au puits 545 du côté où le puits 545 ne touche pas la tranchée 510 d'isolation profonde (du côté droit, en figure 1). Le puits 547 est accolé à la tranchée d'isolation profonde 512 (à gauche de la tranchée 512, en figure 1). La tranchée d'isolation peu profonde 532 est accolée au puits 547 du côté où le puits 547 ne touche pas la tranchée 512 d'isolation profonde (du côté gauche, en figure 1). Une partie de la région 525 de collecteur extrinsèque affleure la surface 501 du substrat 500 entre les tranchées d'isolation peu profondes 530 et 532.

Dans la suite de la description, le mode de mise en œuvre du procédé décrit en relation avec les figures 2 à 17 consiste principalement à réaliser des opérations au-dessus de la surface supérieure 501 du substrat 500. Sauf mention contraire, le substrat 500 des figures 2 à 17 demeure donc identique au substrat 500 tel qu'exposé en relation avec la figure 1. Pour simplifier, le substrat 500 ne sera donc pas à nouveau détaillé dans les figures ci-dessous.

La figure 2 représente, de façon schématique et en coupe, une autre étape du mode de mise en œuvre du procédé de réalisation d'une diode varicap et d'un transistor bipolaire, réalisés à partir de la structure telle que décrite en relation avec la figure 1. L'étape exposée en relation avec la figure 2 est plus particulièrement consacrée à la réalisation d'une partie du futur transistor bipolaire 300.

Au cours de cette étape, on dépose au-dessus de toute la surface supérieure 501 du substrat 500 un empilement 700 de couches successives reposant les unes sur les autres.

Comme illustré en figure 2, cet empilement 700 comprend plus précisément :
une première couche 701 constituée d'un oxyde, par exemple, un oxyde de silicium, recouvrant intégralement la surface supérieure 501 du substrat 500 ;
une deuxième couche 703 constituée préférentiellement de silicium polycristallin d'un deuxième type de conductivité, dans cet exemple, de type p, recouvrant intégralement la surface supérieure de la première couche 701 ;
une troisième couche 705 constituée d'un oxyde, par exemple, le même oxyde que celui dont est constituée la première couche 701, recouvrant intégralement la surface supérieure de la deuxième couche 703 ;
une quatrième couche 707 constituée d'un nitrure, par exemple, un nitrure de silicium, recouvrant intégralement la surface supérieure de la troisième couche 705 ;
une cinquième couche 709 constituée d'un oxyde, par exemple, le même oxyde que celui dont est constituée la première couche 701, recouvrant intégralement la surface supérieure de la quatrième couche 707 ; et
une sixième couche 711 constituée d'un nitrure, par exemple, le même nitrure que celui dont est constituée la quatrième couche 707, recouvrant intégralement la surface supérieure de la cinquième couche 709.

La première couche 701 possède une épaisseur d'environ 50 nm, de préférence égale à 50 nm. La deuxième couche 703 possède une épaisseur d'environ 40 nm, de préférence égale à 40 nm. La troisième couche 705 possède une épaisseur d'environ 5 nm, de préférence égale à 5 nm. La quatrième couche 707 possède une épaisseur d'environ 40 nm, de préférence égale à 40 nm. La cinquième couche 709 possède une épaisseur d'environ 30 nm, de préférence égale à 30 nm. La sixième couche possède une épaisseur d'environ 40 nm, de préférence égale à 40 nm.

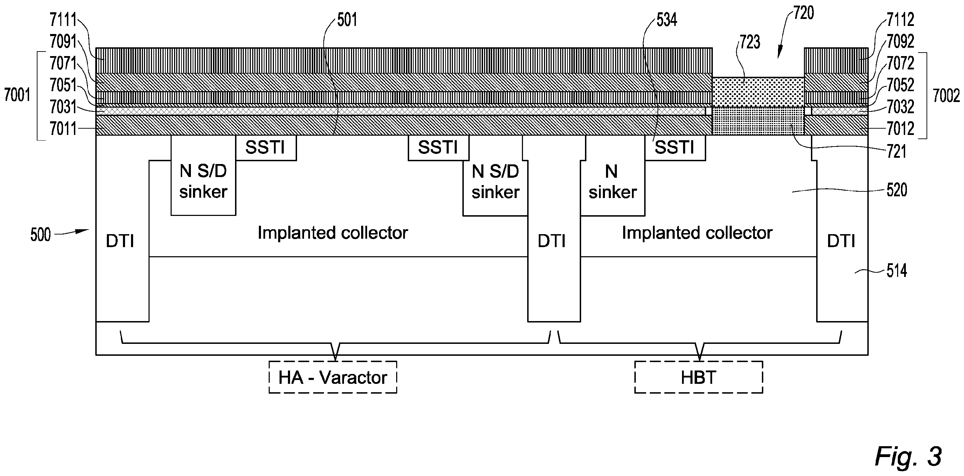

La figure 3 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 2. L'étape exposée en relation avec la figure 3 est plus particulièrement consacrée à la réalisation d'une partie du futur transistor bipolaire 300.

Au cours de cette étape, on grave localement l'empilement 700 (figure 2), sur toute son épaisseur, à l'aplomb d'une partie de la surface supérieure 501 du substrat 500 où affleure la région 520 de collecteur extrinsèque, située à l'emplacement du transistor. Cela revient à pratiquer une ouverture 720 verticale traversant les six couches 701, 703, 705, 707, 709 et 711 de l'empilement 700.

En figure 3, l'ouverture 720 sépare ainsi deux empilements disjoints :
un premier empilement 7001 (à gauche de l'ouverture 720, en figure 3), constitué de premières zones 7011, 7031, 7051, 7071, 7091 et 7111 des couches 701, 703, 705, 707, 709 et 711, respectivement ; et
un deuxième empilement 7002 (à droite de l'ouverture 720, en figure 3), constitué de deuxièmes zones 7012, 7032, 7052, 7072, 7092 et 7112 des couches 701, 703, 705, 707, 709 et 711, respectivement.

On met ainsi à nu une partie de la région 520 de collecteur extrinsèque intercalée, en figure 3, entre la tranchée d'isolation peu profonde 534 et la tranchée d'isolation profonde 514.

On réalise ensuite successivement, dans toute la largeur de l'ouverture 720 et au-dessus de cette partie de la surface supérieure 501 du substrat 500 non recouverte par les empilements 7001 et 7002 :
un premier dépôt 721 d'un matériau dopé du premier type de conductivité, dans cet exemple, le type n ; et
un deuxième dépôt 723 d'un matériau dopé du deuxième type de conductivité, dans cet exemple, le type p, recouvrant toute la surface supérieure du dépôt 721.

Les premier et deuxième dépôts 721 et 723 sont, de préférence, réalisés par épitaxie. Cela permet d'obtenir une interface très marquée entre ces dépôts 721 et 723, donc une jonction p-n caractérisée par un profil de dopants variant de manière très importante au voisinage de cette interface. On parle alors de jonction p-n « abrupte ».

Le premier dépôt 721 possède une épaisseur sensiblement égale à l'épaisseur cumulée de la deuxième zone 7012 de la première couche 701 et de la deuxième zone 7032 de la deuxième couche 703, de préférence égale à l'épaisseur cumulée des deuxièmes zones 7012 et 7032. Le premier dépôt possède ainsi une épaisseur d'environ 90 nm, de préférence égale à 90 nm. Le deuxième dépôt 723 possède une épaisseur d'environ 25 nm, de préférence égale à 25 nm.

Selon ce mode de mise en œuvre, le premier dépôt 721 constitue un collecteur intrinsèque du transistor 300. Le deuxième dépôt 723 constitue une base intrinsèque du transistor 300.

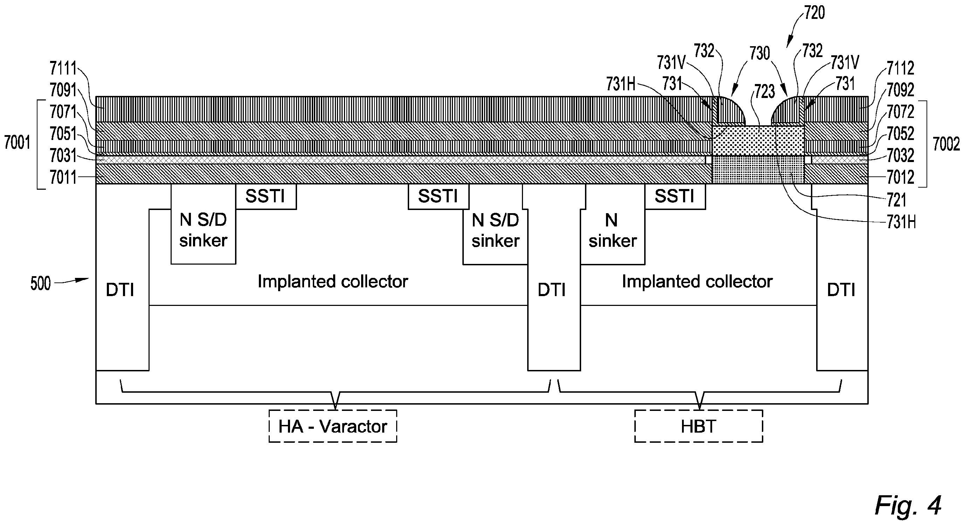

La figure 4 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 3. L'étape exposée en relation avec la figure 4 est plus particulièrement consacrée à la réalisation d'une partie du futur transistor bipolaire 300.

Au cours de cette étape, on réalise deux espaceurs 730 à l'intérieur de l'ouverture 720. Ces deux espaceurs 730 reposent chacun sur une partie de la surface supérieure du deuxième dépôt 723 et bordent intégralement les parois latérales de l'ouverture 720. Les deux espaceurs 730 sont non jointifs, c'est-à-dire qu'ils ne recouvrent pas totalement la surface supérieure du dépôt 723. En figure 4, les espaceurs 730 s'appuient chacun, à l'intérieur de l'ouverture 720, contre une portion de la surface latérale des première et deuxième zones 7091, 7092 de la cinquième couche 709 et contre toute la surface latérale des première et deuxième zones 7111, 7112 de la sixième couche 711.

Dans l'exemple de la figure 4, chaque espaceur 730 comporte une première partie 731 en forme de « L ». Chaque première partie 731 en forme de « L » est constituée d'une portion verticale 731V, correspondant à la branche verticale du « L », et d'une portion horizontale 731H, correspondant à la branche horizontale du « L ». Les premières parties 731 des espaceurs 730 sont, par exemple, en oxyde de silicium.

Les portions verticales 731V des premières parties 731 des espaceurs 730 recouvrent partiellement la surface latérale des première et deuxième zones 7091, 7092 de la cinquième couche 709 et toute la surface latérale des première et deuxième zones 7111, 7112 de la sixième couche 711. Les portions verticales 731V affleurent la surface supérieure des première et deuxième zones 7111, 7112 de la sixième couche 711.

Les portions horizontales 731H recouvrent partiellement la surface supérieure du dépôt 723.

Chaque espaceur 730 comporte, en outre, une deuxième partie 732. Cette deuxième partie 732 est obtenue par un dépôt de nitrure sur les portions horizontales 731H des premières parties 731. On utilise, par exemple, le même nitrure que celui dont est constituée la quatrième couche 707 (figure 2). Ce dépôt est suivi d'une étape de gravure sélective conférant une forme de « D » aux deuxièmes parties 732 des espaceurs 730.

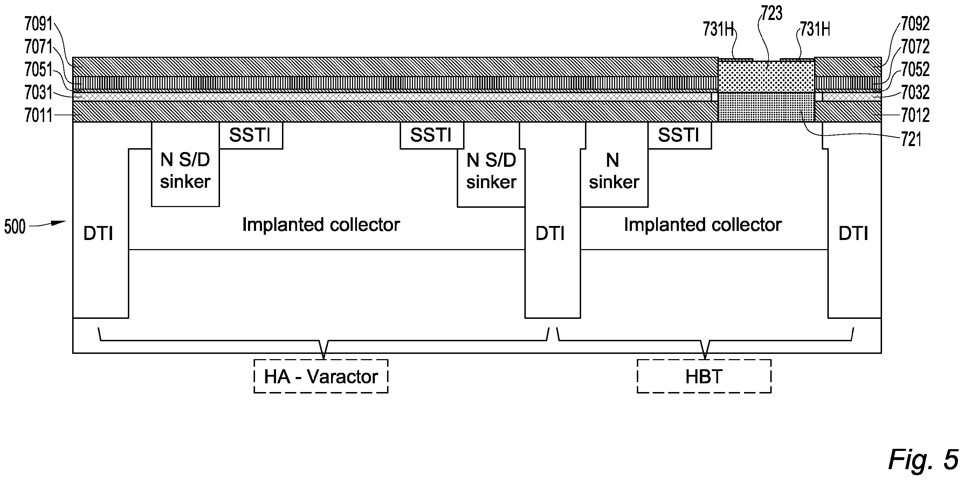

La figure 5 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 4. L'étape exposée en relation avec la figure 5 est plus particulièrement consacrée à la réalisation d'une partie du futur transistor bipolaire 300.

Au cours de cette étape, on procède à une gravure sélective des nitrures se trouvant en surface de la structure telle que décrite en relation avec la figure 4. On élimine ainsi :
l'intégralité des première et deuxième zones 7111, 7112 de la sixième couche 711 ;
les portions verticales 731V des premières parties 731 des espaceurs 730 ; et
les deuxièmes parties 732 des espaceurs 730.

On ne conserve donc que les portions horizontales 731H des premières parties 731 des espaceurs 730, qui recouvrent partiellement la surface supérieure du deuxième dépôt 723. Ces portions horizontales 731H demeurent en contact avec les première et deuxième zones 7091, 7092 de la cinquième couche 709.

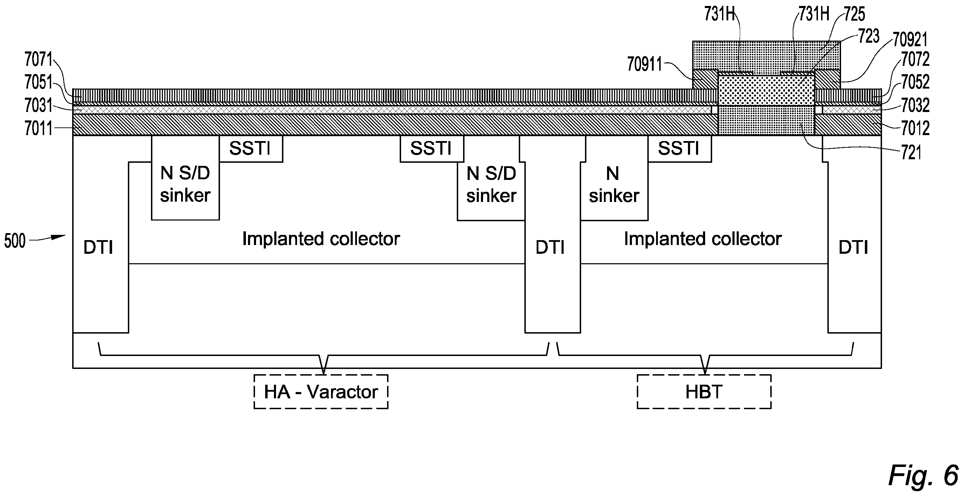

La figure 6 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 5. L'étape exposée en relation avec la figure 6 est plus particulièrement consacrée à la réalisation d'une partie du futur transistor bipolaire 300.

Au cours de cette étape, on vient réaliser un troisième dépôt 725 au-dessus du deuxième dépôt 723 formant la base intrinsèque du transistor 300. Ce troisième dépôt 725 recouvre :
toute la surface supérieure libre du deuxième dépôt 723 ;
toute la surface supérieure de chaque portion horizontale 731H des premières parties 731 des espaceurs 730 ;
une portion 70911 de la première zone 7091 de la couche 709 (à gauche du deuxième dépôt 723, en figure 6) ; et
une portion 70921 de la deuxième zone 7092 de la couche 709 (à droite du deuxième dépôt 723, en figure 6).

Ce troisième dépôt 725 est constitué d'un matériau dopé du premier type de conductivité, dans cet exemple, le type n. Le troisième dépôt 725 constitue un émetteur intrinsèque du transistor 300.

Le troisième dépôt 725 est, de préférence, réalisé par épitaxie. Cela permet d'obtenir une interface très marquée entre les dépôts 725 et 723, donc une jonction p-n caractérisée par un profil de dopants variant de manière très forte au voisinage de cette interface (jonction p-n « abrupte »).

Le troisième dépôt 725 possède une épaisseur d'environ 100 nm, de préférence égale à 100 nm.

Les première et deuxième zones 7091, 7092 de la cinquième couche 709 sont ensuite gravées afin de ne conserver que les portions 70911, 70921 localisées sous le troisième dépôt 725. La figure 6 représente la structure obtenue après cette étape de gravure des première et deuxième zones 7091 et 7092 de la couche 709, c'est pourquoi seules les portions 70911 et 70921 sont visibles en figure 6.

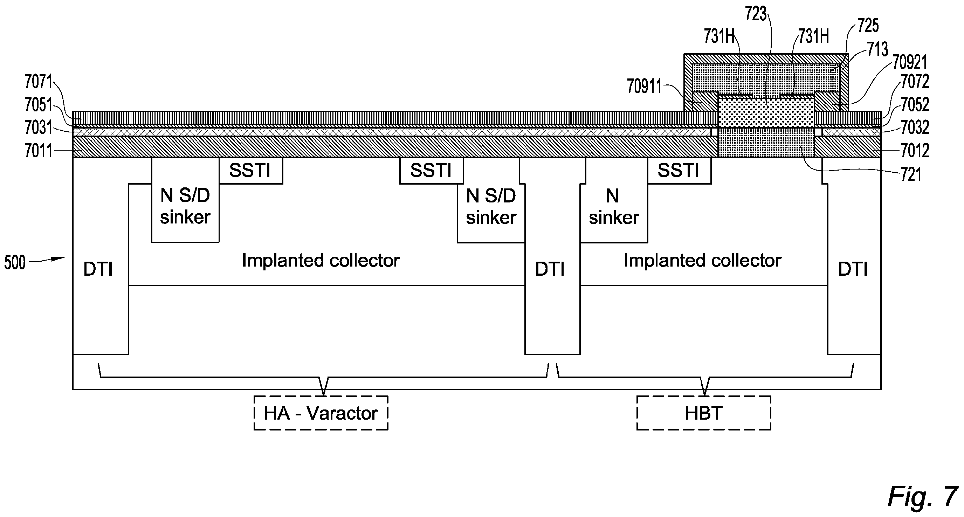

La figure 7 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 6. L'étape exposée en relation avec la figure 7 est plus particulièrement consacrée à la réalisation d'une partie du futur transistor bipolaire 300.

Au cours de cette étape, on recouvre le transistor 300 par une septième couche 713. En figure 7, cette septième couche 713 recouvre ainsi :
la surface supérieure et les surfaces latérales du troisième dépôt 725 ; et
les surfaces latérales libres des portions 70911 et 70921.

Cette septième couche 713 est constituée d'un oxyde, par exemple, le même oxyde que celui dont est constituée la première couche 701 (figure 2).

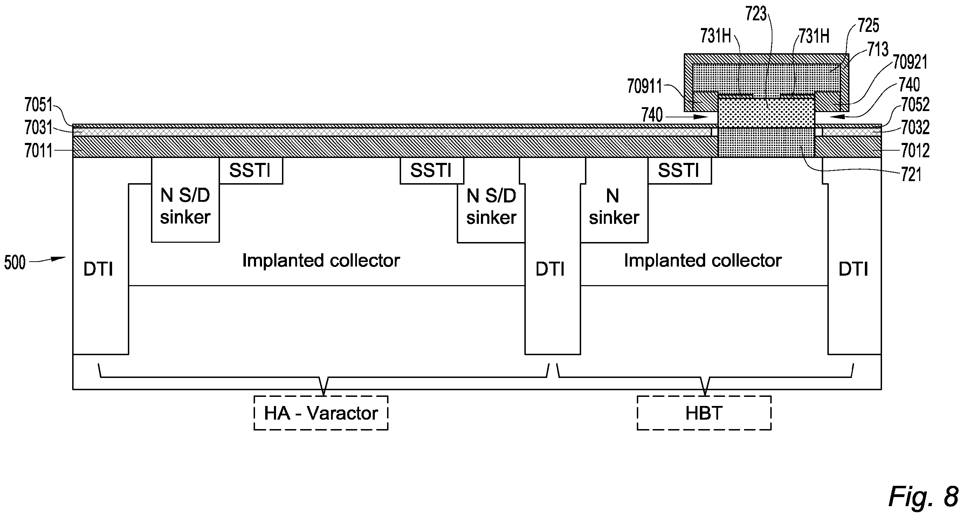

La figure 8 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 7. L'étape exposée en relation avec la figure 8 est plus particulièrement consacrée à la réalisation d'une partie du futur transistor bipolaire 300.

Au cours de cette étape, on grave intégralement les première et deuxième zones 7071, 7072 de la quatrième couche 707, qui ne sont donc pas représentées en figure 8. En d'autres termes, on élimine la totalité des zones 7071 et 7072 de la quatrième couche 707. Cette gravure forme ainsi deux encoches 740 entre :
d'une part les première et deuxième zones 7051, 7052 de la troisième couche 705 ; et
d'autre part les portions 70911, 70921 et la partie inférieure de la septième couche 713.

On met ainsi à nu au moins une partie des surfaces latérales du deuxième dépôt 723 constituant la base intrinsèque du transistor 300.

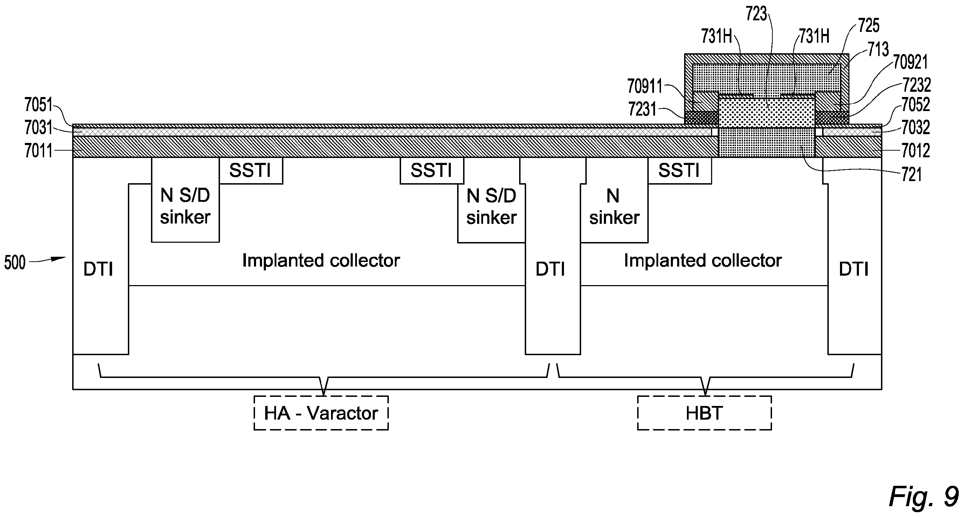

La figure 9 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 8. L'étape exposée en relation avec la figure 9 est plus particulièrement consacrée à la réalisation d'une partie du futur transistor bipolaire 300.

Au cours de cette étape, on vient intégralement combler les encoches 740 (figure 8) par des liens 7231, 7232 (respectivement situés à gauche et à droite du deuxième dépôt 723, en figure 9).

On réalise ces liens 7231 et 7232 par un dépôt d'un matériau dopé du deuxième type de conductivité, dans cet exemple, le type p. On utilise, de préférence, le même matériau que celui dont est constitué le deuxième dépôt 723. Cela revient alors à étendre le deuxième dépôt 723, constituant la base intrinsèque du transistor 300, jusqu'à l'aplomb des surfaces latérales externes de la septième couche 713 recouvrant le troisième dépôt 725.

La figure 10 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 9. L'étape exposée en relation avec la figure 10 est plus particulièrement consacrée à la réalisation d'une partie de la future diode varicap 100.

Au cours de cette étape, on grave localement, sur toute leur épaisseur, les premières zones 7011, 7031 et 7051 des couches 701, 703 et 705, respectivement. Cette gravure est effectuée à l'aplomb d'une partie de la surface supérieure 501 du substrat 500 où affleure la région 525 de collecteur extrinsèque, située à l'emplacement de la diode. Cela revient à pratiquer une ouverture 750 verticale traversante dans les premières zones 7011, 7031 et 7051 des couches 701, 703 et 705. On met ainsi à nu une partie de la région 525 de collecteur extrinsèque intercalée entre les tranchées d'isolation peu profondes 530 et 532. En figure 10, on découvre aussi, lors de la gravure, une partie de la surface supérieure de ces tranchées d'isolation peu profondes 530 et 532.

En figure 10, l'ouverture 750 sépare ainsi :
des premières portions 7013, 7033 et 7053 (situées à gauche de l'ouverture 750, en figure 10) des premières zones 7011, 7031 et 7051 des couches 701, 703 et 705, respectivement ; et
des deuxièmes portions 7014, 7034 et 7054 (situées à droite de l'ouverture 750, en figure 10) des premières zones 7011, 7031 et 7051 des couches 701, 703 et 705, respectivement.

Selon un mode de mise en œuvre préféré, on effectue en outre, sous la partie de la surface supérieure 501 où affleure la région 525 de collecteur extrinsèque, une implantation ionique d'un élément dopant du premier type de conductivité, dans cet exemple, le type n. On crée ainsi, dans le substrat 500, un secteur 527 présentant un dopage accru par rapport au dopage initial, c'est-à-dire avant implantation, au même endroit. Cette opération d'implantation, formant le secteur 527, permet de modifier le profil de dopant de la région 525 de collecteur extrinsèque au voisinage de la surface supérieure 501 du substrat 500.

On suppose, par la suite, que le substrat 500 comporte à présent un secteur 527 tel que décrit précédemment.

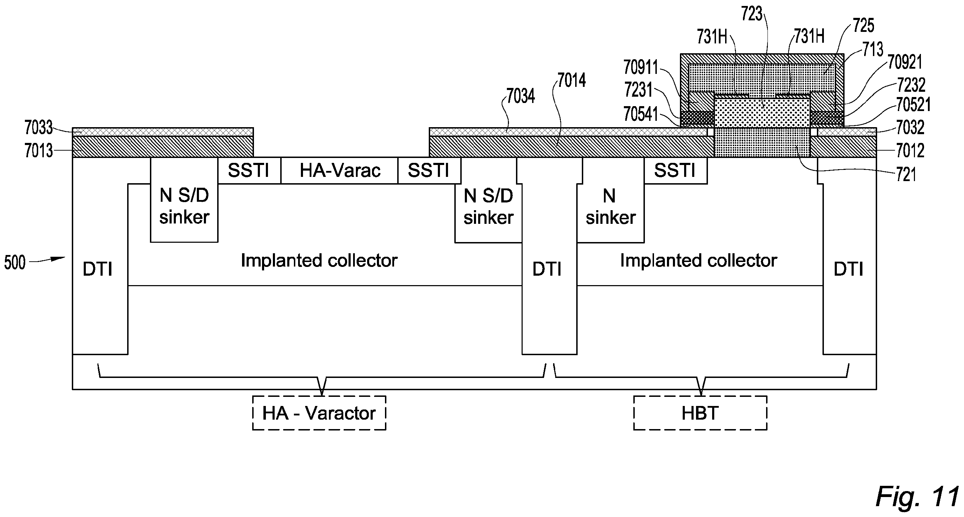

La figure 11 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 10. L'étape exposée en relation avec la figure 11 est plus particulièrement consacrée à la réalisation d'une partie de la future diode varicap 100.

Au cours de cette étape, on procède à une opération de désoxydation pour éliminer la majeure partie de la deuxième zone 7052 de la troisième couche 705 et la majeure partie des première et deuxième portions 7053, 7054 de la première zone 7051 de la troisième couche 705. On conserve ainsi uniquement, à l'emplacement du transistor :
un premier élément 70541 de la deuxième portion 7054, situé à l'aplomb du premier lien 7231 ; et
un deuxième élément 70521 de la deuxième zone 7052, situé à l'aplomb du deuxième lien 7232.

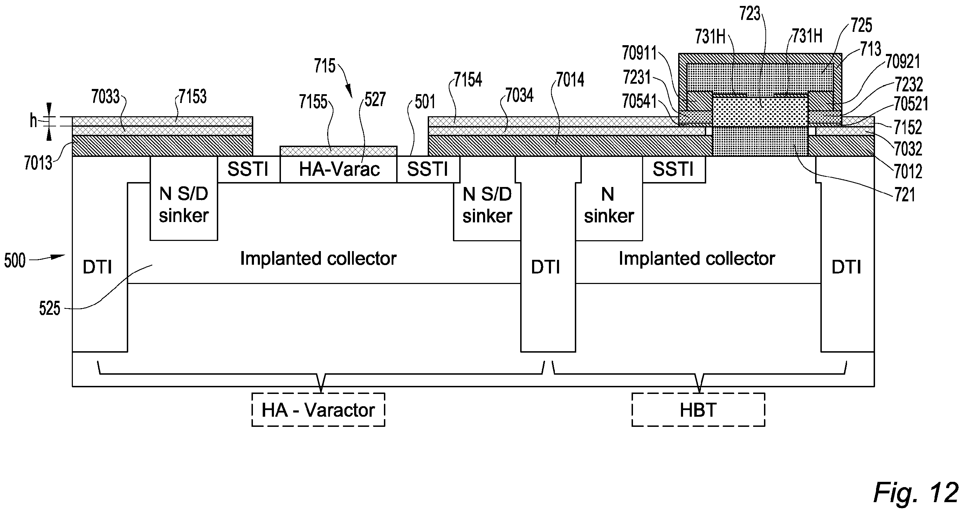

La figure 12 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 11. L'étape exposée en relation avec la figure 12 est plus particulièrement consacrée à la réalisation d'une partie de la future diode varicap 100.

Au cours de cette étape, on procède à un dépôt sélectif d'une huitième couche 715 en surface des parties restantes de la deuxième couche 703 et en surface de la deuxième région 525 de collecteur extrinsèque.

Plus précisément, cette huitième couche 715 est composée de quatre zones :
une première zone 7152 recouvrant toute la surface supérieure libre de la deuxième zone 7032 de la deuxième couche 703 ;
une deuxième zone 7153 recouvrant toute la surface supérieure libre de la première portion 7033 de la première zone 7031 de la deuxième couche 703 ;
une troisième zone 7154 recouvrant toute la surface supérieure libre de la deuxième portion 7034 de la première zone 7031 de la deuxième couche 703 ; et
une quatrième zone 7155 recouvrant, dans l'exemple de la figure 12 où le secteur 527 a été réalisé sous la surface 501 du substrat 500, la surface supérieure de ce secteur 527.

Les zones 7152 à 7155 de la huitième couche 715 sont, par exemple, formées par croissance épitaxiale. On utilise, de préférence, le même matériau que celui dont est constituée la deuxième couche 703 (figure 2). Cela revient alors à :
augmenter l'épaisseur de la zone 7032 et des portions 7033, 7034 restantes de la deuxième couche 703 d'une valeur, notée h, égale à l'épaisseur des zones 7152 à 7154 ; et
créer une zone 7154 à l'aplomb du secteur 527.

Cette épaisseur h est contrôlée de sorte que les zones 7154 et 7152 viennent respectivement contacter les liens 7231 et 7232 situés à l'emplacement du transistor. Les zones 7154 et 7152 sont ainsi, par l'intermédiaire des liens 7231 et 7232, mises en contact avec la base intrinsèque 723 du transistor 300. Les zones 7154 et 7152 de la huitième couche 715 forment alors une base extrinsèque du transistor 300.

La zone 7155 est, dans cet exemple, de type p. Cette zone 7155 forme donc avec le secteur 527, toujours dans cet exemple, de type n, une jonction p-n. En d'autres termes, la zone 7155 forme une région 7155 dopée du deuxième type de conductivité, ici du type p, de la diode 100.

Dans le cas où le substrat 500 ne possède pas de secteur 527 dans sa région 525 de collecteur extrinsèque, la région 7155 et la région 525 forment conjointement la jonction p-n de la diode 100.

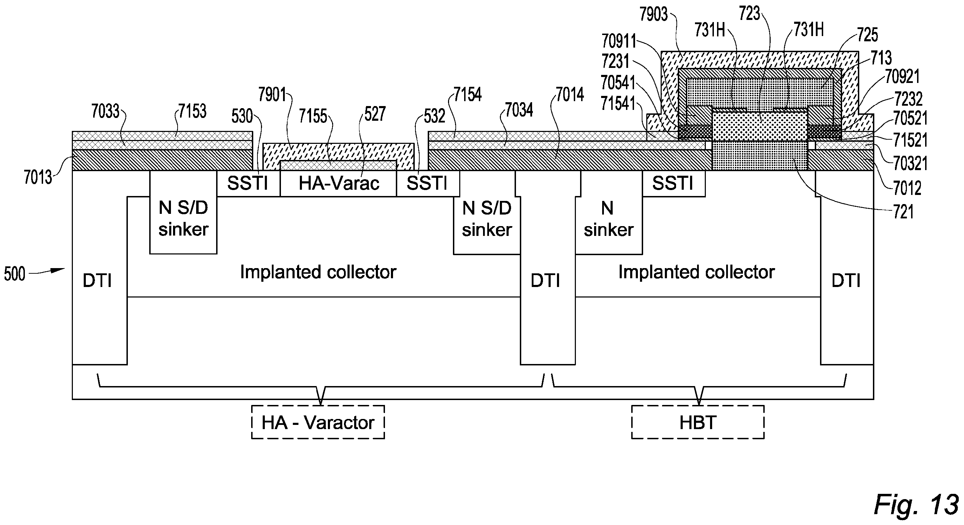

La figure 13 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 12.

Au cours de cette étape, on protège, par une couche sacrificielle, la diode 100 et le transistor 300 en vue d'étapes ultérieures. On recouvre ainsi, à l'emplacement de la diode, la zone 7155 par une première portion 7901 de la couche sacrificielle. En figure 13, les parties latérales de cette portion 7901 recouvrent aussi partiellement les tranchées d'isolation peu profondes 530 et 532.

On recouvre aussi, à l'emplacement du transistor, la structure formant le futur transistor 300 par une deuxième portion 7903 de la couche sacrificielle. En figure 13, cette portion 7903 de couche sacrificielle recouvre notamment :
la face supérieure et les faces latérales de la septième couche 713 ; et
les faces latérales libres des liens 7231 et 7232.

La portion 7903 réalisée à l'emplacement du transistor se prolonge également sur :
une portion 71541 de la zone 7154 située au voisinage du premier lien 7231 ; et
une portion 71521 de la zone 7152 (non visible en figure 13) située au voisinage du deuxième lien 7232.

Ces protections sont, par exemple, effectuées par :
une première opération consistant à déposer la couche sacrificielle constituée, par exemple, d'une photorésine de photolithographie ;
une deuxième opération consistant à insoler, à travers un masque, cette couche sacrificielle de photorésine ; et
une troisième opération consistant à éliminer des parties ainsi insolées de la couche sacrificielle de photorésine.

Le masque est alors conçu de façon à ne conserver, après élimination de la photorésine insolée, que des portions non insolées de la couche de photorésine sacrificielle, dans cet exemple, les première et deuxième portions 7901 et 7903 de la couche sacrificielle.

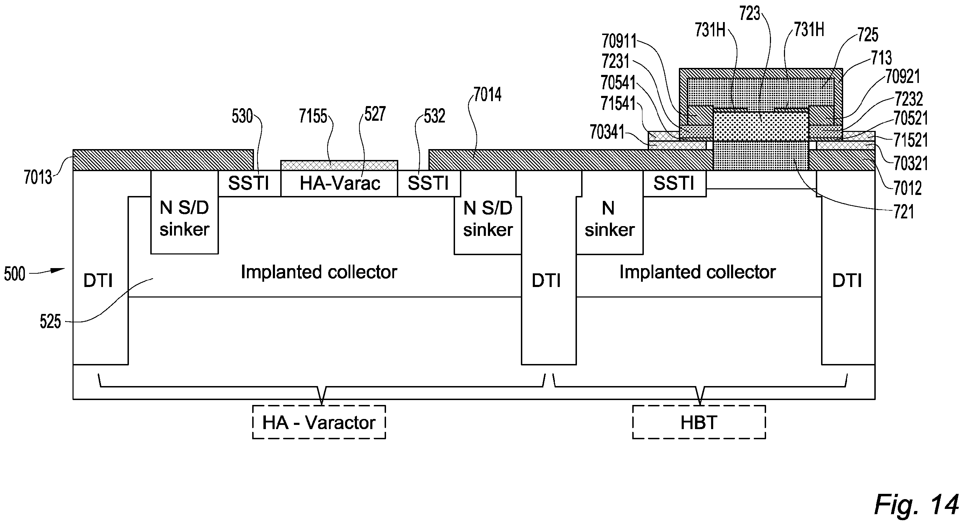

La figure 14 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 13.

Au cours de cette étape, on effectue une opération de gravure, par exemple, par un procédé de gravure sèche (par exemple, une gravure au plasma) pour éliminer toutes les zones non protégées des couches 703 et 715.

Plus précisément, on élimine :
la totalité de la première portion 7033 de la première zone 7031 de la deuxième couche 703 ;
la totalité de la deuxième zone 7153 de la huitième couche 715 ;
une partie de la deuxième portion 7034 de la première zone 7031 de la deuxième couche 703 non située à l'aplomb de la deuxième portion 7903 de la couche sacrificielle ;
une partie de la troisième zone 7154 de la couche 715 non recouverte par la deuxième portion 7903 de la couche sacrificielle ;
une partie de la deuxième zone 7032 (non visible en figure 14) de la deuxième couche 703 non située à l'aplomb de la deuxième portion 7903 de la couche sacrificielle ; et
une partie de la première zone 7152 de la couche 715 non recouverte par la deuxième portion 7903 de la couche sacrificielle.

On retire ensuite les portions 7901 et 7903 (non visibles en figure 14 car retirées à la fin de l'étape d'élimination des zones non protégées listées ci-dessus) de la couche sacrificielle.

On conserve ainsi, comme illustré en figure 14 :
l'intégralité de la quatrième zone 7155 ;
une portion 71541 de la troisième zone 7154 de la couche 715 ;
une portion 71521 de la première zone 7152 de la couche 715 ;
un élément 70341 de la deuxième portion 7034 de la première zone 7031 de la deuxième couche 703, situé à l'aplomb de la portion 71541 et sous une partie de l'élément 70541 ; et
un élément 70321 de la deuxième zone 7032 de la deuxième couche 703, situé à l'aplomb de la portion 71521 et sous une partie de l'élément 70521.

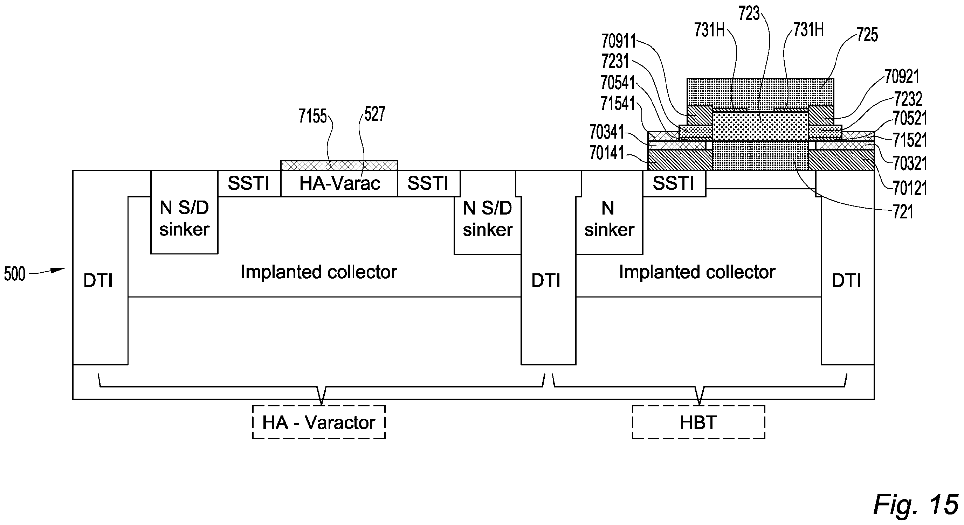

La figure 15 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 14.

Au cours de cette étape, on élimine les parties non recouvertes de la première couche 701 et toute la septième couche 713. Pour cela, on procède à une opération de gravure, par exemple, une gravure humide, de la deuxième zone 7012 de la première couche 701 et des première et deuxième portions 7013 et 7014 de la première zone 7011 de la première couche 701.

Plus précisément, cette opération de gravure a pour effet d'éliminer:
la totalité de la septième couche 713 ;
la totalité de la première portion 7013 de la première zone 7011 de la première couche 701 ;
d'éliminer une partie de la deuxième portion 7014 de la première zone 7011 de la première couche 701 non recouverte par l'élément 70341 ; et
d'éliminer une partie de la deuxième zone 7012 de la première couche 701 non recouverte par l'élément 70321.

On conserve ainsi :
un élément 70141 de la deuxième portion 7014 de la première zone 7011 de la première couche 701, situé à l'aplomb de l'élément 70341 et de l'élément 70541 ;
un élément 70121 de la deuxième zone 7012 de la première couche 701, situé à l'aplomb de l'élément 70321 et de l'élément 70521.

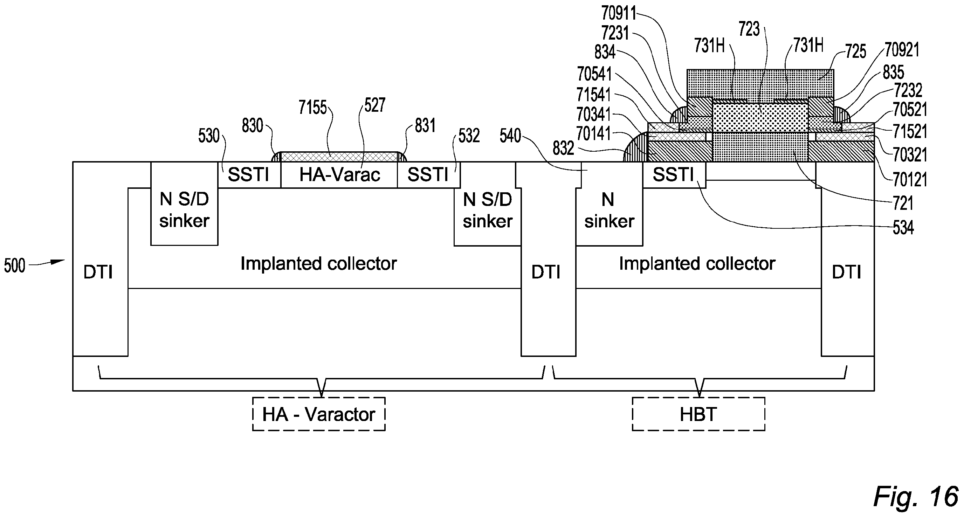

La figure 16 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 15.

Au cours de cette étape, on forme des espaceurs MOS dans des emplacements où la structure telle que décrite en relation avec la figure 15 présente des angles droits. En particulier, on réalise :
deux premiers espaceurs MOS 830 et 831 ;
deux deuxièmes espaceurs MOS 832 (seul un deuxième espaceur MOS 832 est représenté en figure 16) ; et
deux troisièmes espaceurs MOS 834 et 835.

Les premiers espaceurs MOS 830 et 831 sont situés de part et d'autre de la zone 7155 et recouvrent partiellement les tranchées d'isolation peu profondes 530 et 532, respectivement.

Le deuxième espaceur MOS 832 représenté en figure 16 recouvre :
la face latérale libre de l'élément 70341 ;
la face latérale libre de l'élément 70141 ;
la surface libre de la tranchée d'isolation peu profonde 534 ;
une partie de la surface libre du puits 540.

Le deuxième espaceur MOS non représenté en figure 16 est réalisé de façon symétrique par rapport au collecteur intrinsèque 721 du transistor 300.

Les troisièmes espaceurs MOS 834 et 835 recouvrent :
une partie de la surface latérale des portions 70911 et 70921, respectivement ;
une partie de la surface libre, ou des surfaces libres, des liens 7231 et 7232, respectivement ; et
une partie de la surface supérieure des éléments 70541 et 71521, respectivement.

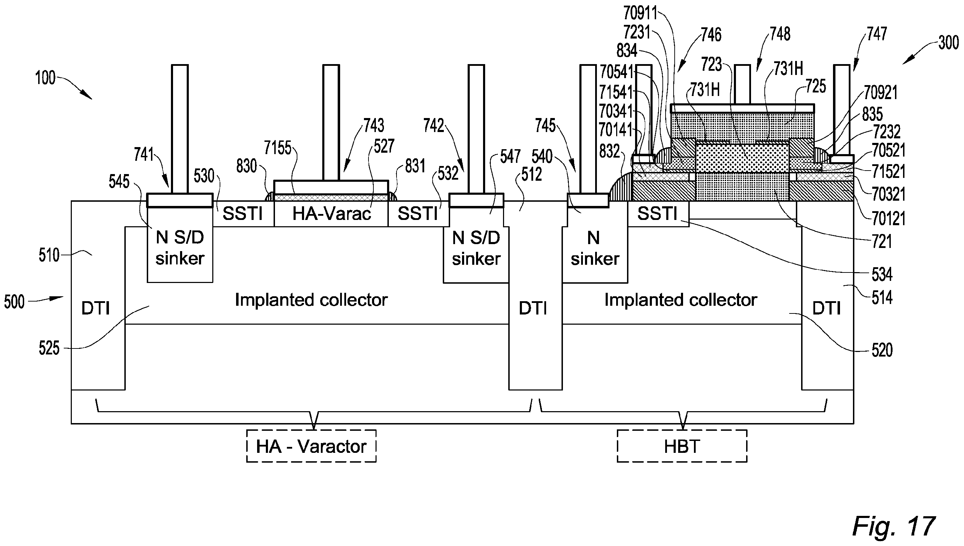

La figure 17 représente, de façon schématique et en coupe, encore une autre étape du mode de mise en œuvre du procédé de réalisation d'une diode varicap et d'un transistor bipolaire, réalisés à partir de la structure telle que décrite en relation avec la figure 16.

Au cours de cette étape, on réalise des premiers éléments 741, 742 et 743 de reprise de contact de la diode varicap 100 et des deuxièmes éléments 745, 746, 747 et 748 de reprise de contact du transistor 300.

Plus particulièrement, pour la diode varicap 100 :
l'élément 741 de reprise de contact est réalisé sur toute la surface supérieure du puits 545 ;
l'élément 742 de reprise de contact est réalisé sur toute la surface supérieure du puits 547 ; et
l'élément 743 de reprise de contact est réalisé sur toute la surface supérieure de la zone 7155.

Les éléments 741 et 742 de reprise de contact sont donc connectés au secteur 527 tandis que l'élément de reprise de contact 743 est connecté à la zone 7155. Le secteur 527 est dopé du premier type, dans cet exemple, le type n. La zone 7155 est dopée du deuxième type, dans cet exemple, le type p.

Les éléments 741 et 742 constituent, dans cet exemple, des contacts ou bornes de cathode de la diode varicap 100. L'élément 743 constitue, toujours dans cet exemple, un contact ou borne d'anode de la diode varicap 100.

Plus particulièrement, pour le transistor 300 :
l'élément 745 de reprise de contact est réalisé sur toute la surface supérieure du puits 540 ;
l'élément 746 de reprise de contact est réalisé sur la surface supérieure de la portion 71541 non recouverte par l'espaceur MOS 734 ;
l'élément 747 de reprise de contact est réalisé sur la surface supérieure de la portion 71521 non recouverte par l'espaceur MOS 735 ;
l'élément 748 de reprise de contact est réalisé sur toute la surface supérieure du troisième dépôt 725.

L'élément 745 de reprise de contact est donc connecté au premier dépôt 721 (collecteur intrinsèque). Les éléments 746 et 747 de reprise de contact sont connectés au deuxième dépôt 723 (base intrinsèque). L'élément 748 de reprise de contact est connecté au troisième dépôt 725 (émetteur intrinsèque).

Le premier dépôt 721 est dopé du premier type, dans cet exemple, le type n. Le deuxième dépôt 723 est dopé du deuxième type, dans cet exemple, le type p. Le troisième dépôt 725 est dopé du premier type, dans cet exemple, le type n.

L'élément 745 de reprise de contact constitue un contact ou borne de collecteur du transistor 300. Les éléments 746 et 747 de reprise de contact constituent des contacts ou bornes de base du transistor 300. L'élément 748 de reprise de contact constitue un contact ou borne d'émetteur du transistor 300.

Le mode de mise en œuvre du procédé dont les étapes successives ont été décrites en relation avec les figures 1 à 17 a l'avantage de permettre de réaliser, en même temps, la diode à capacité variable 100 et le transistor bipolaire 300. Cela réduit donc le nombre d'étapes de fabrication de la diode 100 et du transistor 300 par rapport à un procédé où la diode 100 et le transistor 300 seraient réalisés séparément.

Un autre avantage du mode de mise en œuvre décrit ci-dessus réside dans le fait que la zone 7155 est, de préférence, réalisée par croissance épitaxiale. Dans cet exemple, cela permet ainsi à la zone 7155 et au secteur 527 de former une jonction p-n présentant une interface très marquée, c'est-à-dire au voisinage de laquelle le profil de dopant varie fortement. On obtient ainsi un varactor 100 à jonction p-n « hyperabrupte », en d'autres termes une diode à capacité variable dotée d'un profil de dopants abrupt au voisinage de l'interface de la jonction p-n.

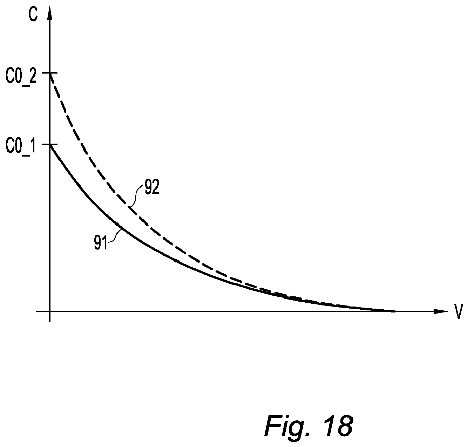

La figure 18 représente des courbes de variation d'une grandeur caractéristique des diodes varicap obtenues selon le mode de mise en œuvre du procédé tel que décrit.

La figure 18 traduit des variations de la capacité électrique (C) de la diode à capacité variable 100 en fonction d'une tension (V) de polarisation inverse appliquée entre l'anode (borne 743 en figure 17) et la cathode (bornes 741 et 742, en figure 17) de la diode 100.

Plus particulièrement :
une première courbe 91 en trait plein illustre la variation de capacité d'une diode 100 dépourvue d'une région 525 à l'intérieur de sa région 525 de collecteur extrinsèque ; et
une deuxième courbe 92 en trait pointillé illustre la variation de capacité d'une diode 100 comportant une région 525 à l'intérieur de sa région 525 de collecteur extrinsèque.

Pour une tension de polarisation V nulle, la diode dépourvue de la région 525 présente une capacité, notée C0_1, inférieure à la capacité, notée C0_2, de la diode comportant la région 525. De manière générale, la présence de la région 525 permet d'accroître la capacité électrique de la diode à capacité variable 100.

Divers modes de réalisation, modes de mise en œuvre et variantes ont été décrits. L'homme de l'art comprendra que certaines caractéristiques de ces divers modes de réalisation, modes de mise en œuvre et variantes pourraient être combinées, et d'autres variantes apparaîtront à l'homme de l'art.

Enfin, la mise en œuvre pratique des modes de réalisation, modes de mise en œuvre et variantes décrits est à la portée de l'homme du métier à partir des indications fonctionnelles données ci-dessus.

## Revendications

1. Procédé de réalisation, conjointement sur un même substrat (500), d'au moins un transistor bipolaire (300) et d'au moins une diode à capacité variable (100), le procédé comprenant les étapes de :
former une première région (7155), d'un premier type de conductivité, d'une jonction p-n de la diode à capacité variable, la première région étant située au-dessus d'une deuxième région (525), d'un deuxième type de conductivité, de la jonction p-n ;
former un collecteur intrinsèque (721), du deuxième type de conductivité, une base intrinsèque (723), du premier type de conductivité, et un émetteur intrinsèque (725), du deuxième type de conductivité, du transistor bipolaire, le collecteur intrinsèque étant situé au-dessus d'une troisième région (520) du deuxième type de conductivité ;
former des premiers espaceurs (830, 831) de part et d'autre de la première région de la jonction p-n de la diode à capacité variable ; et
former des deuxièmes espaceurs (832) de part et d'autre du collecteur intrinsèque du transistor bipolaire.

2. Procédé selon la revendication 1, dans lequel la première région (7155) de la jonction p-n de la diode (100) et une base extrinsèque (7154, 7152) du transistor (300) sont réalisées au cours d'une même étape.

3. Procédé selon la revendication 1 ou 2, dans lequel la première région (7155) est réalisée à l'aplomb d'une région de collecteur extrinsèque (525) constituant la deuxième région.

4. Procédé selon l'une quelconque des revendications 1 à 3, dans lequel la première région (7155) est réalisée par épitaxie.

5. Procédé selon l'une quelconque des revendications 1 à 4, dans lequel un secteur (527) de la deuxième région (525) est dopé par implantation ionique.

6. Procédé selon l'une quelconque des revendications 1 à 5, dans lequel le premier type de conductivité est p et le deuxième type de conductivité est n.

7. Procédé selon l'une quelconque des revendications 1 à 5, dans lequel le premier type de conductivité est n et le deuxième type de conductivité est p.

8. Procédé selon l'une quelconque des revendications 1 à 7, dans lequel la diode (100) est un varactor à jonction p-n hyperabrupte.

9. Procédé selon l'une quelconque des revendications 1 à 8, comportant les étapes suivantes :
prévoir un substrat (500) à l'intérieur duquel la troisième région (520), délimitée latéralement par une première tranchée d'isolation profonde (512) et par une deuxième tranchée d'isolation profonde (514), comporte un premier puits (540) intercalé entre ladite première tranchée d'isolation profonde (512) et une première tranchée d'isolation peu profonde (534) et à l'intérieur duquel ladite deuxième région (525) de collecteur extrinsèque, délimitée latéralement par une troisième tranchée d'isolation profonde (510) et par ladite première tranchée d'isolation profonde (512), comporte un deuxième puits (545), intercalé entre ladite troisième tranchée d'isolation profonde (510) et une deuxième tranchée d'isolation peu profonde (530), et un troisième puits (547) intercalé entre ladite première tranchée d'isolation profonde (512) et une troisième tranchée d'isolation peu profonde (532) ;
former, en surface (501) dudit substrat (500), un empilement (700) constitué d'une première couche (701), d'une deuxième couche (703), recouvrant ladite première couche (701), d'une troisième couche (705), recouvrant ladite deuxième couche (703), d'une quatrième couche (707), recouvrant ladite troisième couche (705), d'une cinquième couche (709), recouvrant ladite quatrième couche (707) et d'une sixième couche (711), recouvrant ladite cinquième couche (709) ;
pratiquer, dans ledit empilement (700) et à l'aplomb d'une partie de ladite surface (501) dudit substrat (500) où affleure ladite troisième région (520), une ouverture (720) traversante séparant ledit empilement (700) en un premier empilement (7001) constitué de premières zones (7011, 7031, 7051, 7071, 7091, 7111) desdites couches (701, 703, 705, 707, 709, 711) et en un deuxième empilement (7002) constitué de deuxièmes zones (7012, 7032, 7052, 7072, 7092, 7112) desdites couches (701, 703, 705, 707, 709, 711) ;
réaliser, dans ladite première ouverture (720), le collecteur intrinsèque (721) et la base intrinsèque (723), la base intrinsèque (723) recouvrant intégralement le collecteur intrinsèque (721) ;
réaliser, dans ladite première ouverture (720), deux troisièmes espaceurs (730) comportant chacun une première partie (731) et une deuxième partie (732), ladite première partie (731) de chaque troisième espaceur (730) étant constituée d'une portion horizontale (731H), recouvrant partiellement la surface supérieure de la base intrinsèque (723), et d'une portion verticale (731V) affleurant la surface supérieure de ladite première zone (7111) de ladite sixième couche (711) ou la surface supérieure ladite deuxième zone (7112) de ladite sixième couche (711) ;
éliminer ladite première zone (7111) de ladite sixième couche (711), ladite deuxième zone (7112) de ladite sixième couche (711), lesdites portions verticales (731V) desdites premières parties (731) desdits troisièmes espaceurs (730) et lesdites deuxièmes parties (732) desdits troisièmes espaceurs (730) ;
réaliser un troisième dépôt (725) au-dessus de la base intrinsèque (723), desdites portions horizontales (731H) desdites premières parties (731) desdits troisièmes espaceurs (730), d'une portion (70911) de ladite première zone (7091) de ladite cinquième couche (709) et d'une portion (70921) de ladite deuxième zone (7092) de ladite cinquième couche (709) ;
éliminer ladite première zone (7091) de ladite cinquième couche (709) à l'exception de ladite portion (70911) de ladite première zone (7091) de ladite cinquième couche (709) et éliminer ladite deuxième zone (7092) de ladite cinquième couche (709) à l'exception de ladite portion (70921) de ladite deuxième zone (7092) de ladite cinquième couche (709) ;
déposer une septième couche (713) recouvrant la surface supérieure dudit troisième dépôt (725), les surfaces latérales dudit troisième dépôt (725), les surfaces latérales de ladite portion (70911) de ladite première zone (7091) de ladite cinquième couche (709) et les surfaces latérales de ladite portion (70921) de ladite deuxième zone (7092) de ladite cinquième couche (709) ;
éliminer la totalité de ladite première zone (7071) de ladite quatrième couche (707) et la totalité de ladite deuxième zone (7072) de ladite quatrième couche (707) ;
réaliser, au-dessous de ladite portion (70911) de ladite première zone (7091) de ladite cinquième couche (709) et d'une portion verticale de ladite septième couche (713), un premier lien (7231) contactant la base intrinsèque (723) et réaliser, au-dessous de ladite portion (70921) de ladite deuxième zone (7092) de ladite cinquième couche (709) et d'une portion verticale de ladite septième couche (713), un deuxième lien (7232) contactant la base intrinsèque (723) ;
pratiquer, à travers lesdites premières zones (7011, 7031, 7051) desdites première (701), deuxième (703) et troisième (705) couches et à l'aplomb d'une partie de ladite surface (501) dudit substrat (500) où affleurent ladite deuxième région (525) de collecteur extrinsèque, une partie de ladite deuxième tranchée d'isolation peu profonde (530) et une partie de ladite troisième tranchée d'isolation peu profonde (532), une deuxième ouverture (750) séparant ladite première zone (7011) de ladite première couche (701) en une première portion (7013) et en une deuxième portion (7014), séparant ladite première zone (7031) de ladite deuxième couche (703) en une première portion (7033) et en une deuxième portion (7034) et séparant ladite première zone (7051) de ladite troisième couche (705) en une première portion (7053) et en une deuxième portion (7054).

10. Procédé selon la revendication 9 comportant, en outre, les étapes suivantes :
éliminer la totalité de ladite première portion (7053) de ladite première zone (7051) de ladite troisième couche (705), éliminer ladite deuxième portion (7054) de ladite première zone (7051) de ladite troisième couche (705) à l'exception d'un premier élément (70541) situé à l'aplomb dudit premier lien (7231) et éliminer ladite deuxième zone (7052) de ladite troisième couche (705) à l'exception d'un deuxième élément (70521) situé à l'aplomb dudit deuxième lien (7232) ;
réaliser une huitième couche (715), une première zone (7152) de ladite huitième couche (715) recouvrant une partie de la surface de la deuxième zone (7032) de ladite deuxième couche (703) non recouverte par ledit deuxième élément (70521), une deuxième zone (7153) de ladite huitième couche (715) recouvrant totalement ladite première portion (7033) de ladite première zone (7031) de ladite deuxième couche (703), une troisième zone (7154) de ladite huitième couche (715) recouvrant une partie de la surface de la deuxième portion (7034) de ladite première zone (7031) de ladite deuxième couche (703) non recouverte par ledit premier élément (70541) et une quatrième zone de ladite huitième couche (715) constituant ladite première région (7155) ;
déposer une couche sacrificielle, une première portion (7901) de ladite couche sacrificielle recouvrant ladite première région (7155) et une deuxième portion (7903) de ladite couche sacrificielle recouvrant ladite septième couche (713), ledit premier lien (7231) et ledit deuxième lien (7232), ladite deuxième portion (7903) de ladite couche sacrificielle s'étendant latéralement sur un premier élément (71541) de ladite troisième zone (7154) de ladite huitième couche (715) et sur un deuxième élément (71521) de ladite première zone (7152) de ladite huitième couche (715) ;
éliminer des parties desdites zones (7152, 7153, 7154, 7155) et portions (7032, 7033, 7034) de ladite huitième couche (715) et de ladite deuxième couche (703) non recouvertes par lesdites première (7901) et deuxième (7903) portions de ladite couche sacrificielle ;
éliminer totalement ladite première portion (7013) de ladite première zone (7011) de ladite première couche (701), éliminer ladite deuxième portion (7014) de ladite première zone (7011) de ladite première couche (701) à l'exception d'un cinquième élément (70141) recouvert par ledit troisième élément (70341) et éliminer ladite deuxième zone (7012) de ladite première couche (701) à l'exception d'un sixième élément (70121) recouvert par ledit quatrième élément (70321) ;
réaliser les premiers espaceurs (830, 831) de part et d'autre de ladite première région (7155), réaliser les deuxièmes espaceurs (832) de part et d'autre du collecteur intrinsèque (721) et réaliser des quatrièmes espaceurs (834, 835) de part et d'autre de la base intrinsèque (723) ;
réaliser un premier élément (741) de reprise de contact sur ladite deuxième tranchée (545), un deuxième élément (742) de reprise de contact sur ladite troisième tranchée (547), un troisième élément (743) de reprise de contact sur ladite première région (7155), un quatrième élément (745) de reprise de contact sur ledit premier puits (540), un cinquième élément (746) de reprise de contact sur ledit premier élément (71541) de ladite troisième zone (7154) de ladite huitième couche, un sixième élément (747) de reprise de contact sur ledit deuxième élément (71521) de ladite première zone (7152) de ladite huitième couche (715) et un septième élément (748) de reprise de contact sur ledit troisième dépôt (725), lesdits premier (741), deuxième (742) et troisième (743) éléments de reprise de contact constituant des bornes de ladite diode à capacité variable (100), ledit quatrième (745) élément de reprise de contact constituant une borne de collecteur dudit transistor bipolaire (300), lesdits cinquième (746) et septième (747) éléments de reprise de contact constituant des bornes de base dudit transistor bipolaire (300) et ledit huitième (748) élément de reprise de contact constituant une borne d'émetteur dudit transistor bipolaire (300) .

11. Circuit électronique comportant au moins un varactor (100) et au moins un transistor bipolaire (300), obtenus par le procédé selon l'une quelconque des revendications 1 à 10.
